Europäisches Patentamt

European Patent Office

Office européen des brevets

(11) Veröffentlichungsnummer: **0 264 635 B1**

(12) **EUROPÄISCHE PATENTSCHRIFT**

(45) Veröffentlichungstag der Patentschrift: **21.08.91**

(51) Int. Cl.⁵: **C09J 201/02**, H01B 1/22, H01L 23/48

(21) Anmeldenummer: 87113706.3

(22) Anmeldetag: 18.09.87

(54) **Elektrisch leitfähiger Klebstoff für hohen Temperaturbereich.**

(30) Priorität: 25.09.86 DE 3632628

(43) Veröffentlichungstag der Anmeldung:
27.04.88 Patentblatt 88/17

(45) Bekanntmachung des Hinweises auf die
Patenterteilung:
21.08.91 Patentblatt 91/34

(84) Benannte Vertragsstaaten:
DE FR IT

(56) Entgegenhaltungen:
EP-A- 0 027 240     EP-A- 0 032 728
FR-A- 2 366 677     US-A- 4 051 454
US-A- 4 130 707     US-A- 4 552 688

(73) Patentinhaber: **Siemens Aktiengesellschaft
Wittelsbacherplatz 2
W-8000 München 2(DE)**

Patentinhaber: **WACKER-CHEMIE GMBH
Prinzregentenstrasse 22
W-8000 München 22(DE)**

(72) Erfinder: **Peltz, Hanns-Heinz
Wörthstrasse 23
W-8000 München 80(DE)**
Erfinder: **Wolfer, Dietrich, Dr. Chem.
Untereching 88
A-5110 Salzburg(AT)**

(74) Vertreter: **Fuchs, Franz-Josef, Dr.-Ing. et al
Postfach 22 13 17
W-8000 München 22(DE)**

**Beschreibung**

Die vorliegende Erfindung bezieht sich auf einen elektrisch leitfähigen Klebstoff, wie im Oberbegriff des Patentanspruches 1 angegeben.

Zur Herstellung von elektrischen Oberflächenwellenfiltern, großflächigen IC-Halbleiterschaltungen und entsprechenden elektronischen Bauelementen wird Klebstoff verwendet, um das Substrat des Filters bzw. der IC-Schaltung und dgl. auf einer z.B. metallischen Unterlage aufzukleben. Diese Unterlage ist z.B. ein Bestandteil des Gehäuses des fertigen Bauelementes.

Substrate für derartige Filter sind z.B. bis zu mehreren cm lange und z.B. etwa 0,5 mm dicke Plättchen aus einkristallinem Lithiumniobat oder -tantalat. Für IC-Schaltungen werden Substratplättchen aus Silizium oder auch aus anderen Halbleitermaterial verwendet. Die genannten Materialien haben gemeinsame Eigenschaften, nämlich daß sie gegen mechanische Verspannungen relativ empfindlich sind bzw. daß sie zum Zerbrechen bzw. zu Rissen neigen, wenn sie entsprechenden mechanischen Spannungen unterworfen werden. Insbesondere für Oberflächenwellenfilter kommt noch der Nachteil hinzu, daß auch schon lediglich mechanische Deformation, insbesondere Biegung, des Substrats zu sogar außerordentlich starken Änderungen der elektrischen Werte des Bauelements führt.

Ein Oberflächenwellenfilter bzw. eine IC-Schaltung ist auf bzw. in einer Oberfläche des Substrats in bekannter Weise realisiert. Mit der gegenüberliegenden Oberfläche des Substrats ist dieses Substrat mittels des Klebstoffes mit der Unterlage verbunden. Die Unterlage liegt elektrisch auf Masse und bildet eine elektrische Abschirmung für die elektronische Struktur des Filters bzw. der IC-Schaltung auf der erstgenannten Oberfläche. Für solche Bauelemente kommt es aber häufig darauf an, daß diese auf Masse liegende Abschirmung möglichst dicht an der Zone der elektrischen Struktur liegt. Wird elektrisch leitfähiger Kleber mit dafür ausreichend hoher elektrischer Leitfähigkeit verwendet, so liegt diese Abschirmung an der der elektronischen Struktur gegenüberliegenden Oberfläche des Substrats, d.h. erheblich näher an dieser jeweiligen elektronischen Struktur. Es empfiehlt sich nämlich, die Dicke der Klebstoffschicht relativ dick zu machen, d.h. so dick zu machen, daß diese Klebstoffschicht weitestgehend sämtliche mechanischen Spannungen infolge der Elastizität bzw. Viskosität des Klebstoffes aufzunehmen vermag, die auf unterschiedlichen Temperaturkoeffizienten der Ausdehnung des Materials des Substrats einerseits und des Materials der Unterlage andererseits beruhen.

Stand der Technik ist es, als Klebstoff für derartige Zwecke Epoxi-Silber-Kleber zu verwenden, der im Temperaturbereich zwischen etwa 0 und 125°C zufriedenstellende Ergebnisse liefert. Es gibt aber zahlreiche Anwendungsfälle, in denen ein erheblich erweiterter Temperaturbereich des elektrischen Betriebs oder zumindestens der Lagerung des Bauelements zu berücksichtigen ist. Ein typischer geforderter Temperaturbereich erstreckt sich von -40°C bis +180°C.

Für den letztgenannten großen Temperaturbereich ergeben sich Schwierigkeiten vor allem bei niedrigen Temperaturen, bei denen Epoxi-Kleber so hart wird, daß er die erforderliche Elastizität für den notwendigen Ausgleich der innerhalb des Klebstoffes auftretenden Spannungen nicht zu erfüllen vermag. Eine Folge dieses unzulänglichen Verhaltens ist, daß das Substrat Risse bekommt und das Bauelement unbrauchbar wird. Aber auch bereits thermisch bedingte Verbiegungen des Substrats können aus der Sicht der elektronischen Anwendung nicht in Kauf genommen werden.

Es ist eine Aufgabe der vorliegenden Erfindung, Maßnahmen anzugeben, mit deren Hilfe für derartige Bauelemente der geforderte größere Temperaturbereich zu beherrschen ist.

Diese Aufgabe wird mit einem Klebstoff mit den Merkmalen des Patentanspruches 1 gelöst und weitere Ausgestaltungen und Weiterbildungen der Erfindung gehen aus den Unteransprüchen hervor.

Es ist nicht unüblich, bekannte Silikonkleber allgemein zu verwenden. Vielfache Versuche solchen Kleber für der Erfindung zugrundeliegende Anwendungen zu benutzen, führten jedoch schließlich zu der Feststellung, daß auf diesem Wege die obige Aufgabe nicht zu lösen ist. Insbesondere war es schwierig, dabei auch die erforderlich hohe elektrische Leitfähigkeit zu erzielen.

Eine elektrisch leitfähige Klebstoffzusammensetzung mit Vinylgruppen enthaltenden Organopolysiloxanen und Organosiloxanen mit an Silizium gebundenem Wasserstoff ist aus der US 4 051 454 bekannt und wird insbesondere zum Verkleben von flexiblem Widerstandsheizmaterial mit Metallelektroden verwendet.

Eine weitere Klebstoffzusammensetzung mit vinylgruppenhaltigen Organosiloxanen ist aus der EP-A 0 027 240 bekannt und wird zum Beispiel zum Verkleben von Verbundglasschichten oder zum Verbinden von Silizium-Halbleiterlementen mit entsprechenden Unterlagen verwendet.

Überraschenderweise wurde eine günstige Lösung gefunden, wobei von einer Masse ausgegangen worden war, die zur Verwendung als Beschichtung von Glasgewebe und Isolierschläuchen und dgl., jedoch bisher nicht als Klebstoff, vorgesehen ist. Diese Masse ist nachfolgend noch näher definiert.

Insbesondere für die eingangs angegebenen elektronischen Bauelemente und speziell für Oberflächenwellenfilter ist die Verwendung von Stoffen, insbesondere eines Klebers, mit sogar auch nur langzeitig abdampfenden Komponenten tabu, da sich abgedampfte Produkte auf den Strukturen niederschlagen und deren Eigenschaften nachhaltig verändern. Die angestellten Versuche zeigten aber, daß hier doch ein Weg zur Lösung aller gestellter Aufgabenparameter zu finden ist. In eine solche Masse läßt sich nämlich vorzugsweise bei Raumtemperatur mit guter Endverteilung handelsübliches teilchenförmiges Silber einrühren. Es ist in eine z.B. 10-%ige, nachfolgend definierte Masse solches Silber in derartiger Menge mit einer derart homogenen Verteilung eingerührt worden, daß als Endergebnis ausreichende und mit Epoxi-Silber-Kleber durchaus vergleichbare Leitfähigkeitswerte zu erzielen sind. Ein solches Ergebnis läßt sich aber erst über weitere der Erfindung gemäße Verfahrensschritte erzielen. Diese mit (e) Organopolysiloxan mit Si-gebundenem Wasserstoff zu einem Elastomer vernetzbare Masse, enthält im wesentlichen:

(a) Diorganopolysiloxan mit Vinyldimethylsiloxaneinheiten als endständige Einheiten, wobei in den Diorganosiloxaneinheiten die beiden SiC-gebundenen organischen Reste von aliphatischen Mehrfachbindungen freie Kohlenwasserstoffreste sind,

(b) als Füllstoff verwendbares anorganisches Oxyd mit einer BET-Oberfläche von mindestens 50 m²/g,

(c) organisches Lösungsmittel und

(d) die Anlagerung von Si-gebundenem Wasserstoff an Vinylgruppen fördernden Katalysator.

Bevorzugte Diorganopolysiloxane (a) sind solche, die vorzugsweise 200 bis 800 Siliziumatome je Molekül enthalten, wobei andere Kohlenwasserstoffreste als Vinylgruppen in diesen Diorganopolysiloxanen vorzugsweise Methylreste sind.

Das Diorganopolysiloxan (a) liegt vorzugsweise in Mengen von 10 bis 30 Gew.-%, bezogen auf das Gesamtgewicht der Bestandteile (a), (b), (c) und (d) vor.

Die Organopolysiloxane (e) sind vorzugsweise solche der Formel

$$R\ Si\ (CH_3)_2\ O\ (SiR_2O)_p\ Si\ (CH_3)_2\ R$$

wobei R Wasserstoff oder den Methyl-, Ethyl- und/oder Phenylrest bedeutet mit den Maßgaben, daß an ein Siliziumatom jeweils nur ein Wasserstoffatom gebunden sein kann, je Siliziumatom durchschnittlich mindestens 0,2 Si-gebundene Wasserstoffatome und je Molekül mindestens 3 Si-gebundene Wasserstoffatome vorliegen und p eine ganze Zahl mit einem solchen Wert ist, daß die Viskosität dieser Organopolysiloxane (e) 4 bis 150 mPa.s bei 25 °C beträgt.

Organopolysiloxan (e) wird vorzugsweise in Mengen von 1 bis 3 Gew.-%, bezogen auf das Gesamtgewicht der Bestandteile (a) bis (e) und des Silberpulvers, verwendet.

Als anorganisches Oxyd (b) wird pyrogen erzeugtes Siliziumdioxyd mit einer BET-Oberfläche von 100 bis 200 m²/g bevorzugt.

Anorganisches Oxyd (b) wird vorzugsweise in Mengen von 10 bis 40 Gew.-%, bezogen auf das Gewicht an Diorganopolysiloxan (a), verwendet.

Bevorzugt werden als Lösungsmittel (c) bei Raumtemperatur und 1020 hPa (abs.) flüssige und bei höchstens 200 °C bei 102 0 hPa (abs.) siedende Kohlenwasserstoffe, wie Toluol, Xylol-Isomerengemische, Leichtbenzin, einschließlich n-Pentan verwendet, wobei n-Pentan besonders bevorzugt ist.

Als Katalysator (d) werden vorzugsweise Platin oder eine Platinverbindung oder ein Platinkomplex verwendet, und zwar insbesondere ein von anorganisch gebundenem Halogen freier Platin-Vinylsiloxan-Komplex.

Es empfiehlt sich, zusätzlich zu den vorstehend genannten Bestandteilen ein übliches Mittel zur Verhinderung der Anlagerung von Si-gebundenem Wasserstoff an Vinylgruppen bei Raumtemperatur, wie Maleinsäuremonoethylester, zu verwenden.

Als teilchenförmiges Silber kann plättchenförmiges Silber (z.B. F14 der Fa. Demetron) verwendet werden. Vorteilhaft ist auch die Verwendung von kugelförmigem Silber. Sehr gute Ergebnisse wurden auch mit dendritischem Silber erzielt, wie es auch für Foto-Filmemulsion verwendet wird.

Nach dem beschriebenen Einrühren des teilchenförmigen Silbers wird die Dispersion durch vorzugsweise höhere Temperatur und ggf. auch Anwendung von Unterdruck eingedickt, nämlich durch Entzug in dieser Masse enthaltenen Lösungsmittels. Eine Besonderheit der Erfindung ist, daß der Masse praktisch sämtlicher Lösungsmittelgehalt entzogen werden kann bzw. entzogen wird. Das erzielte Produkt ist Silikon mit darin zu hohem Prozentsatz homogen verteilten Silber. Dieses Produkt hat durchaus die für die Verwendung als Klebstoff günstige pastöse Viskosität.

Erfindungsgemäß wird in die Masse ein derartig hoher Prozentsatz des Silbers eingerührt, daß das sich ergebende pastöse Endprodukt, d.h. der Kleber, eine derart hohe elektrische Leitfähigkeit besitzt, wie sie mit Epoxi-Silber-Klebern vergleichbar ist.

Mit einem Silbergehalt von 75 Gew.-% läßt sich ein Durchgangswiderstand kleiner als $4 . 10^{-3}$ Ohm/cm erreichen.

Die beigefügte Figur zeigt in Seitenansicht einen an wendungsgemäßen Kleber. Mit 1 ist eine Unterlage aus z.B. Kupfer bezeichnet, die z.B. auch ein Teil des Gehäuses des betreffenden Bauelements ist. Mit 2 ist das Substratplättchen eines Oberflächenwellenfilters bezeichnet. Die zwischen Unterlage und Substrat befindliche Klebschicht, bestehend aus erfindungsgemäßem kleber, ist mit 3 bezeichnet. Infolge der guten elektrischen Leitfähigkeit des erfindungsgemäßen Klebers liegt die Ebene der elektrischen Abschirmung in der Grenzfläche zwischen dem Kleber 3 und dem Substrat 2 (und nicht in der Ebene der Oberfläche der Unterlage 1).

Bei Änderungen der Umgebungstemperatur eines derartigen Bauelementes ergeben sich erheblich unterschiedliche thermische Ausdehnungen für die Unterlage 1 einerseits und das Substrat 2 andererseits. Der erfindungsgemäße Kleber hat jedoch eine derartige Elastizität, insbesondere auch bei Temperaturen bis herab zu -40° C, daß nicht nur die Verbindungswirkung des Klebstoffs ohne Frage aufrechterhalten bleibt, sondern daß auch das Substrat 2 keinen wesentlichen mechanischen Verspannungen ausgesetzt ist, insbesondere keinen solchen, die zu Rissen des Substrats führen könnten, wie dies bei Anwendung bisher verwendeten Klebers ohne weiteres der Fall ist.

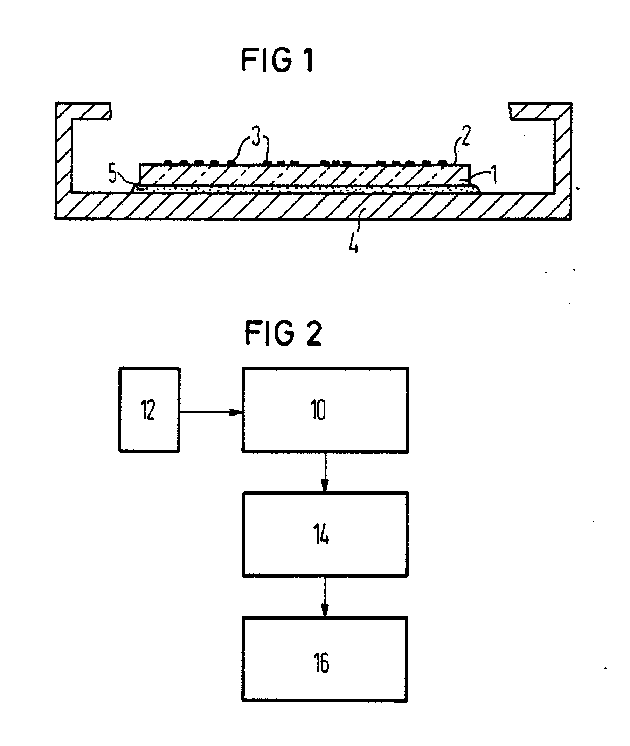

Figur 1 zeigt in Seitenansicht im Schnitt ein Oberflächenwellenfilter, wie es aus dem Stand der Technik bekannt ist. Mit 1 ist das Substrat bezeichnet, auf dessen Oberfläche 2 je nach Vorgabe für dieses Oberflächenwellenfilter Wandler- und/oder Reflektorstrukturen 3 angeordnet sind. Mit 4 ist die Unterlage für das Substrat 1 bezeichnet, wobei diese Unterlage 4 bereits Teil des Gehäuses ist. Mit 5 ist die aus erfindungsgemäßem Klebstoff bestehende Klebstoffschicht bezeichnet, mit der das Substrat 1 auf der Unterlage 4 gehaltert ist.

Die Materialeigenschaften des für die Schicht 5 verwendeten erfindungsgemäßen Klebstoffes gewährleisten, daß thermische Ausdehnungen der Unterlage 4 nicht zu Verspannungen und/oder Verbiegungen des Substrats 1 und damit des ganzen Oberflächenwellenfilters führen. Aufgrund der vernachlässigbaren Abdampfung des für die Schicht verwendeten Klebstoffes ist bei der Erfindung auch das mit derartigen Abdampfungen verbundene Problem behoben. Es ist nämlich zu berücksichtigen, daß das Oberflächenwellenfilter in dem Gehäuse 4 hermetisch gegenüber der Umgebung abgeschlossen ist und Abdampfungen zwangsläufig innerhalb des Gehäuses verbleiben.

Figur 2 zeigt ein Fließbild zur Herstellung eines erfindungsgemäßen Klebstoffes. Mit 10 ist auf den Verfahrensschritt des Einrührens des der Masse zugegebenen teilchenförmigen Silbers hingewiesen. Mit 14 ist auf das Eindicken dieser Masse hingewiesen. Das Ergebnis ist der pastöse Klebstoff 16.

**Patentansprüche**

1. Elektrisch leitfähiger Klebstoff zum flächigen Verbinden von entsprechend flächigen Teilen miteinander, die voneinander unterschiedliche Temperaturkoeffizienten der Ausdehnung ihrer starren, nicht flexiblen Materialien haben, **gekennzeichnet dadurch,** daß als Klebstoff für einen Temperaturbereich von -60° C bis +180° C ein Produkt verwendet wird, das wie folgt hergestellt ist:
in eine durch Zusatz von (e) Organopolysiloxan mit Si gebundenem Wasserstoff zu einem Elastomer vernetzbare Masse, die als wesentliche Bestandteile (a) 10 bis 30 Gewichtsprozent Diorganopolysiloxan mit Vinyldimethylsiloxaneinheiten als endständigen Einheiten, wobei in den Diorganosiloxaneinheiten die beiden SiC-gebundenen organischen Reste von aliphatischen Mehrfachbindungen freie Kohlenwasserstoffreste sind, (b) 10 bis 40 Gewichtsprozent (bezogen auf Komponente a) als Füllstoff verwendbares anorganisches Oxyd mit einer BET-Oberfläche von mindestens 50 m²/g, (c) organisches Lösungsmittel und (d) die Anlagerung von Si-gebundenem Wasserstoff an Vinylgruppen fördernden Katalysator enthält, wird teilchenförmiges Silber eingerührt, dann diese Masse bis zum Erreichen des pastösen Verarbeitungszustandes eingedickt bis praktisch der gesamte Lösungsmittelanteil der ursprünglichen Masse aus dem Klebstoff entfernt ist, und das so erhaltene Gemisch vor der endgültigen Verwendung mit Organopolysiloxan (e) vermischt, wobei der im Verfahrensschritt des Einrührens zugegebene Silbergehalt in dem eingedickten Zustand mehr als 75 Gewichtsprozent beträgt.

2. Klebstoff nach Anspruch 1, **gekennzeichnet dadurch,** daß praktisch sämtlicher Lösungsmittelanteil der ursprünglichen Masse beim Eindicken aus dem Klebstoff entfernt ist.

3. Klebstoff nach einem der Ansprüche 1 bis 2, **gekennzeichnet dadurch,** daß plättchenförmiges Silber enthalten ist.

4. Klebstoff nach einem der Ansprüche 1 bis 2, **gekennzeichnet dadurch,** daß kugelförmiges Silber enthalten ist.

5. Klebstoff nach einem der Ansprüche 1 bis 2, **gekennzeichnet dadurch,** daß dendritisches Silber enthalten ist.

6. Klebstoff nach einem der Ansprüche 1 bis 5,

gekennzeichnet dadurch,
daß das Diorganopolysiloxan (a) im wesentlichen 200 bis 800 Siliziumatome je Molekül enthält und die anderen Kohlenwasserstoffreste als Vinylgruppen in diesen Diorganopolysiloxanen im wesentlichen Methylreste sind.

7. Klebstoff nach einem der Ansprüche 1 bis 6 **gekennzeichnet dadurch,**
daß das Diorganopolysiloxan (a) in Mengen von 10 bis 30 Gew.-%, bezogen auf das Gesamtgewicht der Bestandteile (a), (b), (c) und (d) der Masse vorliegt.

8. Klebstoff nach einem der Ansprüche 1 bis 7, **gekennzeichnet dadurch,**
daß als Organopolysiloxane (e) solches der Formel

R Si (CH$_3$)$_2$ O (SiR$_2$O)$_p$ Si (CH$_3$)$_2$R

verwendet ist, wobei R Wasserstoff oder den Methyl-, Ethyl- und/oder Phenylrest bedeutet mit den Maßgaben, daß an ein Siliziumatom jeweils nur ein Wasserstoffatom gebunden sein kann, je Siliziumatom durchschnittlich mindestens 0,2 Si-gebundene Wasserstoffatome und je Molekül mindestens 3 Si-gebundene Wasserstoffatome vorliegen und p eine ganze Zahl mit einem solchen Wert ist, daß die Viskosität dieser Organopolysiloxan e (e) 4 bis 150 mPa.s bei 25° C beträgt.

9. Klebstoff nach einem der Ansprüche 1 bis 8, **gekennzeichnet dadurch,**
daß das Organopolysiloxan (e) in Mengen von 1 bis 3 Gew.-%, bezogen auf das Gesamtgewicht der Bestandteile (a) bis (e) und des Silberanteils, verwendet ist.

10. Klebstoff nach einem der Ansprüche 1 bis 9, **gekennzeichnet dadurch,**
daß das anorganische Oxyd (b) pyrogen erzeugtes Siliziumdioxyd mit einer BET-Oberfläche von 100 bis 200 m²/g ist.

11. Klebstoff nach einem der Ansprüche 1 bis 10, **gekennzeichnet dadurch,**
daß das anorganische Oxyd (b) in Mengen von 10 bis 40 Gew.-%, bezogen auf das Gewicht zu Diorganopolysiloxan (a), vorliegt.

12. Klebstoff nach einem der Ansprüche 1 bis 11, **gekennzeichnet dadurch,**
daß als Lösungsmittel (c) bei Raumtemperatur und 1020 hPa (abs.) flüssige und bei höchstens 200° C bei 1020 hPa (abs.) siedende Kohlenwasserstoffe verwendet sind.

13. Klebstoff nach Anspruch 12, **gekennzeichnet dadurch,**
daß das Lösungsmitteln-Pentan ist.

14. Klebstoff nach einem der Ansprüche 1 bis 13, **gekennzeichnet dadurch,**
daß als Katalysator (d) Platin, eine Platinverbindung oder ein Platinkomplex verwendet ist.

15. Klebstoff nach Anspruch 14, **gekennzeichnet dadurch,**
daß ein von anorganisch gebundenem Halogen freier Platin-Vinylsiloxan-Komplex verwendet ist.

16. Klebstoff nach einem der Ansprüche 1 bis 15, **gekennzeichnet dadurch,**
daß zusätzlich ein übliches Mittel zur Verhinderung der Anlagerung von Si-gebundenem Wasserstoff an Vinylgruppen bei Raumtemperatur verwendet ist.

17. Klebstoff nach Anspruch 16, **gekennzeichnet dadurch,**
daß dieses Mittel Maleinsäuremonoethylester ist.

**Claims**

1. Electrically conductive adhesive for the planar joining to one another of correspondingly planar parts which have mutually different coefficients of thermal expansion of their rigid, non-flexible materials, characterised in that, as an adhesive for a temperature range from -60° C to +180° C, use is made of a product which is produced as follows:
particulate silver is stirred into a mixture which can be crosslinked to form an elastomer by adding (e) organopolysiloxane containing Si-bound hydrogen, which mixture contains as essential constituents (a) 10 to 30 percent by weight of diorganopolysiloxane having vinyldimethylsiloxane units as terminal units, the two SiC-bound organic radicals in the diorganosiloxane units being hydrocarbon radicals which are free of aliphatic multiple bonds, (b) 10 to 40 percent by weight (based on component a) of an inorganic oxide which is usable as a filler and has a BET surface of at least 50 m²/g, (c) an organic solvent and (d) a catalyst which promotes the attachment of Si-bound hydrogen to vinyl groups, said mixture is then concentrated until the pasty processing state is reached and virtually the entire solvent component of the original mixture has been removed from the adhesive, and the mixture so obtained is mixed before being finally used with organopolysiloxane (e), the silver content added in the process step of stirring-in being more than 75 percent by weight in the concentrated state.

2. Adhesive according to Claim 1, characterised in that virtually all the solvent component of the original mixture is removed from the adhesive on concentrating.

3. Adhesive according to one of Claims 1 to 2, characterised in that it contains platelet-like silver.

4. Adhesive according to one of Claims 1 to 2, characterised in that it contains spherical silver.

5. Adhesive according to one of Claims 1 to 2, characterised in that it contains dendritic silver.

6. Adhesive according to one of Claims 1 to 5, characterised in that the diorganopolysiloxane (a) essentially contains 200 to 800 silicon atoms per molecule and the hydrocarbon radicals other than vinyl groups in said diorganopolysiloxanes are essentially methyl radicals.

7. Adhesive according to one of Claims 1 to 6, characterised in that the diorganopolysiloxane (a) is present in amounts of 10 to 30% by weight, based on the total weight of the constituents (a), (b), (c) and (d) of the mixture.

8. Adhesive according to one of Claims 1 to 7, characterised in that, as organopolysiloxanes (e) those of the formula

R Si (CH₃)₂ O (SiR₂O)p Si (CH₃)₂R

are used, where R is hydrogen or the methyl, ethyl and/or phenyl radical, with the proviso that only one hydrogen atom can be bound in each case to a silicon atom, at least 0.2 Si-bound hydrogen atoms are on average present per silicon atom and at least 3 Si-bound hydrogen atoms are present per molecule and p is an integer having a value such that the viscosity of said organopolysiloxanes (e) is 4 to 150 mPa.s at 25° C.

9. Adhesive according to one of Claims 1 to 8, characterised in that the organopolysiloxane (e) is used in amounts of 1 to 3 parts by weight, based on the total weight of the constituents (a) to (e) and of the silver component.

10. Adhesive according to one of Claims 1 to 9, characterised in that the inorganic oxide (b) is pyrogenically produced silicon dioxide having a BET surface of 100 to 200 m²/g.

11. Adhesive according to one of Claims 1 to 10, characterised in that the inorganic oxide (b) is present in amounts of 10 to 40% by weight, based on the weight of diorganopolysiloxane (a).

12. Adhesive according to one of Claims 1 to 11, characterised in that hydrocarbons which are liquid at room temperature and 1020 hPa (abs.) and which boil at not more than 200° C at 1020 hPa (abs.) are used as solvent (c).

13. Adhesive according to Claim 12, characterised in that the solvent is pentane.

14. Adhesive according to one of Claims 1 to 13, characterised in that platinum, a platinum compound or a platinum complex is used as catalyst (d).

15. Adhesive according to Claim 14, characterised in that a platinum vinylsiloxane complex which is free of inorganically bound halogen is used.

16. Adhesive according to one of Claims 1 to 15, characterised in that a standard agent for preventing the attachment of Si-bound hydrogen to vinyl groups at room temperature is additionally used.

17. Adhesive according to Claim 16, characterised in that said agent is monoethyl maleate.

**Revendications**

1. Produit adhésif conducteur de l'électricité pour relier superficiellement entre elles des parties présentant des surfaces adéquates, et dont les coefficients de dilatation en fonction de la température de leurs matériaux non souples et rigides diffèrent entre eux, caractérisé en ce qu'il consiste à utiliser comme produit adhésif, pour une plage de température de -60° C à +180° C, un produit préparé de la manière suivante :

dans une composition, qui peut être réticulée en un élastomère par addition de (e) un organopolysiloxane ayant de l'hydrogène lié au Si, et qui contient, comme constituants essentiels, (a) de 10 à 30 % en poids d'un diorganopolysiloxane ayant des motifs vinyldiméthylsiloxane comme motifs terminaux, les deux radicaux organiques liés à SiC dans les motifs diorganosiloxane étant des radicaux hydrocarbonés exempts de liaisons multiples aliphatiques, (b) de 10 à 40 % en poids (par rapport au constituant a) d'un oxyde minéral qui peut être utilisé comme charge et qui a une surface BET d'au moins 50 m²/g, (c) un solvant organique et (d) un catalyseur favorisant l'addition d'hydrogène lié à Si à des groupes vinyle, on introduit, tout en agitant, de l'argent sous forme de particules, puis on concentre cette composition jusqu'à obtention de l'état de traitement pâteux, pratiquement toute la proportion de solvant de la composition initiale étant éliminée du produit adhésif, et on mélange le mélange ainsi obtenu, avant l'utilisation définitive, à un organopolysiloxane (e), la teneur en argent ajouté au stade du procédé de l'introduction sous agitation représentant, à l'état concentré, plus de 75 % en poids.

2. Produit adhésif suivant la revendication 1,
   caractérisé,
   en ce que pratiquement toute la proportion du solvant de la composition initiale est éliminée du produit adhésif, lors de la concentration.

3. Produit adhésif suivant l'une des revendications I à 2,
   caractérisé,
   en ce qu'il contient de l'argent sous forme de plaquettes.

4. Produit adhésif suivant l'une des revendications 1 à 2,
   caractérisé,
   en ce qu'il contient de l'argent sous forme de billes.

5. Produit adhésif suivant l'une des revendications 1 à 2,
   caractérisé,
   en ce qu'il contient de l'argent dendritique.

6. Produit adhésif suivant l'une des revendications 1 à 5,
   caractérisé,
   en ce que le diorganopolysiloxane (a) contient sensiblement de 200 à 800 atomes de silicium par molécule et les autres radicaux hydrocarbonés servant de groupes vinyle dans ces diorganopolysiloxanes sont essentiellement des radicaux méthyle.

7. Produit adhésif suivant l'une des revendications 1 à 6,
   caractérisé,
   en ce que le diorganopolysiloxane (a) représente de 10 à 30 % du poids total des constituants (a), (b), (c) et (d) de la composition.

8. Produit adhésif suivant l'une des revendications I à 7,
   caractérisé,
   en ce que sont utilisés, comme organopolysiloxane (e), ceux de formule

   $$R \, Si \, (CH_3)_2 \, O \, (SiR_2O)_p \, Si \, (CH_3)_2 R$$

   dans laquelle R est l'hydrogène ou le radical méthyle, éthyle et/ou phényle, sous la condition que seul un atome d'hydrogène peut être lié à un atome de silicium, chaque atome de silicium présentant en moyenne au moins 0,2 atome d'hydrogène lié au Si et chaque molécule au moins 3 atomes d'hydrogène liés au Si et p est un nombre entier ayant une valeur telle que la viscosité de ces organopolysiloxanes (e) est comprise entre 4 et 150 mpa.s à 25°C.

9. Produit adhésif suivant l'une des revendications 1 à 8,
   caractérisé,
   en ce que l'organopolysiloxane (e) est utilisé en des quantités représentant de 1 à 3 % du poids total des constituants (a) à (e) et de la proportion d'argent.

10. Produit adhésif suivant l'une des revendications 1 à 9,
    caractérisé,
    en ce que l'oxyde minéral (b) est du dioxyde de silicium pyrogène et ayant une surface BET de 100 à 200 m²/g.

11. Produit adhésif suivant l'une des revendications I à 10,
    caractérisé,
    en ce que l'oxyde minéral (b) représente de 10 à 40 % du poids du diorganopolysiloxane (a).

12. Produit adhésif suivant l'une des revendications 1 à 11,
    caractérisé,
    en ce qu'on utilise, comme solvant (c), ces hydrocarbures liquides à la température ambiante et sous 1020 hPa (absolus) et bouillant au plus à 200°C sous 1020 hPa (absolus).

13. Produit adhésif suivant la revendication 12,
    caractérisé,
    en ce que le solvant est du pentane.

**14.** Produit adhésif suivant l'une des revendications 1 à 13,

caractérisé,

en ce qu'on utilise, comme catalyseur (d), du platine, un composé de platine ou un complexe de platine.

**15.** Produit adhésif suivant la revendication 14,

caractérisé,

en ce qu'on utilise un complexe platine-vinylsiloxane exempt d'halogène à liaison minérale.

**16.** Produit adhésif suivant l'une des revendications 1 à 15,

caractérisé,

en ce qu'on utilise en outre un agent habituel pour empêcher l'addition d'hydrogène lié au Si à des groupes vinyle à la température ambiante.

**17.** Produit adhésif suivant la revendication 16, caractérisé,

en ce que cet agent est l'ester monoéthylique de l'acide maléique.

# FIG 1

# FIG 2